(19)

**Europäisches Patentamt**
**European Patent Office**
**Office européen des brevets**

(11)  **EP 4 568 453 B1**

(12)  **EUROPEAN PATENT SPECIFICATION**

(45) Date of publication and mention
of the grant of the patent:
**15.07.2026  Bulletin 2026/29**

(51) International Patent Classification (IPC):
**H10F 39/18** (2025.01)  **H10F 39/00** (2025.01)

(21) Application number: **24212189.5**

(22) Date of filing: **11.11.2024**

(52) Cooperative Patent Classification (CPC):
**H10F 39/18; H10F 39/805; H10F 39/8063;**
**H10F 39/8067;** H10F 39/199; H10F 39/802

(54) **SINGLE PHOTON AVALANCHE DIODE ARRAY, RECEIVING SENSOR AND LIDAR**

EINZELPHOTONEN-LAWINENDIODENANORDNUNG, EMPFANGSSENSOR UND LIDAR

RÉSEAU DE DIODES À AVALANCHE À PHOTON UNIQUE, CAPTEUR DE RÉCEPTION ET LIDAR

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**

(30) Priority:  **30.11.2023  CN 202311637529**

(43) Date of publication of application:
**11.06.2025  Bulletin 2025/24**

(60) Divisional application:
**26183318.0**

(73) Proprietor: **Suteng Innovation Technology Co.,**
**Ltd**
**Shenzhen City Guangdong 518000 (CN)**

(72) Inventors:
• **CHAO, Enfei**
**Shenzhen (CN)**
• **XIA, Chunqiu**
**Shenzhen (CN)**
• **YAO, Guofeng**
**Shenzhen (CN)**

(74) Representative: **Ran, Handong et al**
**Maucher Jenkins**
**Seventh Floor Offices**
**Artillery House**
**11-19 Artillery Row**
**London SW1P 1RT (GB)**

(56) References cited:
CN-U- 209 216 990     CN-U- 219 958 996
US-A1- 2021 151 490     US-A1- 2021 183 930

EP 4 568 453 B1

**Description**

TECHNICAL FIELD

The present application relates to the technical field of optical devices, and in particular, relates to a single photon avalanche diode array, a receiving sensor and a LiDAR.

BACKGROUND

Single photon avalanche diode (SPAD) arrays have been widely used in laser detection and ranging systems (LiDAR), autonomous driving, fluorescence lifetime imaging, quantum communication, biomedical imaging and other scenarios due to their high sensitivity detection capability for intensities as low as single photons, high time resolution capability, strong anti-interference ability, etc., and at least two SPADs are connected in parallel as a single-point silicon photomultiplier tube (SiPM). With the advancement of silicon manufacturing technology, the single photon avalanche diode arrays using silicon as absorption and avalanche materials has become a hot topic in the industry. In addition, by utilizing various CMOS manufacturing technologies, SPADs can be easily integrated with different quenching circuits and readout circuits, so they have huge technical advantages.

Single photon avalanche diode array can be combined in circuits to form two typical application forms. The first is the silicon photomultiplier (SiPM), which includes at least two single photon avalanche diode array units connected in parallel, and outputs a signal as a whole. Since the pulse signals generated for different photons can be superimposed, the SiPM can respond to different light intensities and perform single-point output. Another typical form is the SPAD array. Each SPAD unit acts as a separate pixel, and the light intensity detected by each pixel can be output separately. It has the ability to detect photons in parallel, so it can directly form images. Its imaging performance in some weak-light environments is very good, such as biomedical microscopy, fluorescence lifetime microscopy, flash radar, etc.

However, optical crosstalk is a critical and difficult problem to solve for both SiPM and SPAD arrays. For SiPM, crosstalk photons cause SPAD units that have no incident photons to be excited. A large optical crosstalk probability will overestimate the energy of the received signal, causing problems such as incorrect calculation of object reflectivity and increased distance measurement errors. For SPAD arrays, imaging expansion and abnormal output of entire rows or columns will occur.

US2021183930A1 discloses a solid-state imaging device applicable to, for example, CMOS image sensors. The imaging device includes a pixel unit in which a plurality of pixels each having a light detection unit are arranged; a micro lens formed on a light incident surface side of the light detection unit for each of the pixels; and a light-shielding unit that is formed around the micro lens and shields light. The micro lens is formed inside an opening part provided in the light-shielding part.

SUMMARY

Embodiments of the present application provide a single photon avalanche diode array and a silicon photomultiplier tube, which aim to solve the problem that crosstalk photons in the current single-photon avalanche diode array cause the SPAD units that have no incident photons to be excited, resulting in a higher probability of optical crosstalk. The invention is set out in the appended set of claims.

A first aspect of an embodiment of the present application provides a single photon avalanche diode array, the single photon avalanche diode array comprising: at least two SPAD units; at least two micro lenses, corresponding to the at least two SPAD units respectively, and the micro lenses are used to focus incident light onto the corresponding SPAD units; at least two front metal wiring layers, wherein the at least two front metal wiring layers correspond one-to-one to the at least two SPAD units; a back metal grid for connecting the SPAD unit to a corresponding external electrode; a first dielectric layer disposed between the micro lens and the SPAD unit and used to reduce reflection of the incident light; a second dielectric layer provided between the SPAD unit and the front metal wiring layer; wherein the front metal wiring layer is electrically connected to the corresponding SPAD unit through a contact metal wire; a deep groove separation column provided between adjacent SPAD units and used to separate the adjacent SPAD units; and a metal filling structure arranged between the deep groove separation column and the back metal grid and used to suppress self-excited photons generated by the SPAD units excited by the incident light from entering adjacent SPAD units through a grid gap.

In an embodiment, a vertical cross-section of the back metal grid is an inverted trapezoid.

In an embodiment, a vertical cross section of the back metal grid is a multi-layer stepped structure, and a width of each step in the multi-layer stepped structure gradually increases.

In an embodiment, a vertical cross-section of the back metal grid is an arc-shaped structure, which is used to reflect photons irradiating its surface to the SPAD unit.

In an embodiment, an intermetallic dielectric layer is provided between adjacent front metal wiring layers, an etch stop layer is provided between the intermetallic dielectric layer and the deep groove separation column, the deep groove separation column penetrates into the etch stop layer and divides the second dielectric layer into at least two dielectric units, and at least two dielectric units correspond to the SPAD unit.

In an embodiment, an intermetallic dielectric layer is provided between adjacent front metal routing layers, an etch stop layer is provided between the intermetallic dielectric layer and the deep groove separation column, and a length of the portion of the deep groove separation column that penetrates into the second dielectric layer is greater than half of the thickness of the second dielectric layer.

In an embodiment, the SPAD unit includes a first doping region and a second doping region stacked on the second dielectric layer, and the first doping region and the second doping region form a PN junction.

In an embodiment, the deep groove separation column is made of metal tungsten.

In an embodiment, the metal filling structure is a ring structure.

A second aspect of the embodiments of the present application provides a silicon photomultiplier tube, which includes the single photon avalanche diode array.

A third aspect of the embodiments of the present application provides a receiving sensor, which includes a single photon avalanche diode array.

A fourth aspect of the embodiments of the present application provides a receiving sensor, which includes a silicon photomultiplier tube.

A fifth aspect of the embodiments of the present application provides a LiDAR, which includes an emitting sensor and a receiving sensor, the emitting sensor is used to emit a detection laser, and the receiving sensor is used to receive an echo of the detection laser and obtain detection information of a target object based on the echo.

At least two SPAD units are arranged in an array, the micro lens converges the incident light onto the corresponding SPAD unit, the back metal grid connects the SPAD unit with the corresponding external electrode, the first dielectric layer is arranged between the micro lens and the SPAD unit, the second dielectric layer is arranged between the SPAD unit and the front metal wiring layer, and the front metal wiring layer is electrically connected to the corresponding SPAD unit through the contact metal wire. By arranging deep groove separation columns between adjacent SPAD units and arranging a metal filling structure between the deep groove separation columns and the back metal grid, the self-excited photons generated by the SPAD unit excited by the incident light can be isolated, and the self-excited photons are prevented from entering the adjacent SPAD unit through the grid gap, thereby reducing the overflow of self-excited photons, reducing the probability of photon crosstalk, and reduce the optical crosstalk of the device.

BRIEF DESCRIPTION OF DRAWINGS

FIG. 1 is a schematic diagram of a single photon avalanche diode array provided in an embodiment;
FIG. 2 is a schematic top view of a single photon avalanche diode array provided in an embodiment;
FIG. 3 is a schematic diagram of a cross section AA of a single photon avalanche diode array provided in an embodiment;
FIG. 4 is a schematic diagram of a cross section BB of a single photon avalanche diode array provided in an embodiment;
FIG. 5 is a schematic diagram of a single photon avalanche diode array provided in an embodiment;
FIG. 6 is a schematic diagram of a single photon avalanche diode array provided in an embodiment;
FIG. 7 is a schematic diagram of a single photon avalanche diode array provided in an embodiment;
FIG. 8 is a schematic diagram of a single photon avalanche diode array provided in an embodiment;
FIG. 9 is a schematic diagram of a single photon avalanche diode array provided in an embodiment;
FIG. 10 is a schematic diagram of a single photon avalanche diode array provided in an embodiment;
FIG. 11 is a schematic diagram eight of a single photon avalanche diode array provided in an embodiment;
FIG. 12 is a schematic diagram of self-excited crosstalk of a one-dimensional linear array provided in an embodiment;
FIG. 13 is schematic diagram of self-excited crosstalk of a two-dimensional array provided in an embodiment;
FIG. 14 is schematic diagram of crosstalk light fields of a structure and a metal filling structure extension solution provided in an embodiment;
FIG. 15 is a schematic diagram of crosstalk light fields of a structure and a deep groove separation column extension solution provided in an embodiment;
FIG. 16 is a schematic diagram of self-excited photon crosstalk of a device structure when a deep groove separation column extension and a metal filling structure closed-loop solution (such as FIG. 9) are simultaneously adopted according to an embodiment;
FIG. 17 is schematic diagrams of the improvement of the self-excited crosstalk of the device structure in the comprehensive solution (such as FIG. 11) provided in an embodiment.

DETAILED DESCRIPTION

In order to make the technical problems, technical solutions and beneficial effects to be solved more clearly understood, embodiments of the present application is further described in detail below in conjunction with the accompanying drawings and embodiments.

An element is referred to as being "fixed to" or "disposed on" another element, it can be directly on the other element or indirectly on the other element. When an element is referred to as being "connected to" another element, it can be directly connected to the other element or indirectly connected to the other element.

The terms "length", "width", "up", "down", "front", "back", "left", "right", "vertical", "horizontal", "top", "bottom", "inside", "outside", etc., indicating the orientation or position relationship, are based on the orientation or position relationship shown in the drawings, and are only for the convenience of describing the embodiments and simplifying the description, and do not indicate or imply that the device or element referred to must have a specific orientation, be constructed and operated in a specific orientation.

The terms "first" and "second" are used for descriptive purposes only and should not be understood as indicating or implying relative importance or implicitly indicating the number of technical features indicated. Therefore, the features defined as "first" and "second" may explicitly or implicitly include one or more than two of the features. In the description of this application, " at least two " means one or more than one, unless otherwise clearly and specifically defined.

Single-photon avalanche diode arrays (SPADs) have the advantages of high sensitivity detection capability for intensities as low as single photons, high time resolution, and strong anti-interference ability. Silicon photomultiplier tubes (SiPMs) includes at least two SPADs connected in parallel as a single point have been widely used in scenarios such as laser detection and ranging systems (LiDAR), autonomous driving, fluorescence lifetime imaging, quantum communications, and biomedical imaging.

In order to reduce the crosstalk characteristics of the device, the device can be optimized at the device level, packaging level and system level. However, the crosstalk improvement solution at the system level only avoids the impact of crosstalk on signal reading, which comes at the cost of complex scanning methods and circuit implementation, and does not solve the optical crosstalk problem. The crosstalk improvement solution at the packaging level is similar. The crosstalk at the device level is the most essential, but there are not many means that can be used. Although the crosstalk characteristics of FSI devices (front-illuminated receiving devices) are better, their low PDE limits. The industry still uses back-illuminated (BSI) devices with higher PDE; the introduction of deep groove separation columns (DTI) can greatly reduce optical crosstalk, but it mainly reduces the crosstalk of adjacent SPADs. The far-end SPAD can still be affected by crosstalk through other paths. In particular, for SiPM devices, chain avalanche triggering may be caused, causing large-area devices to be affected by crosstalk.

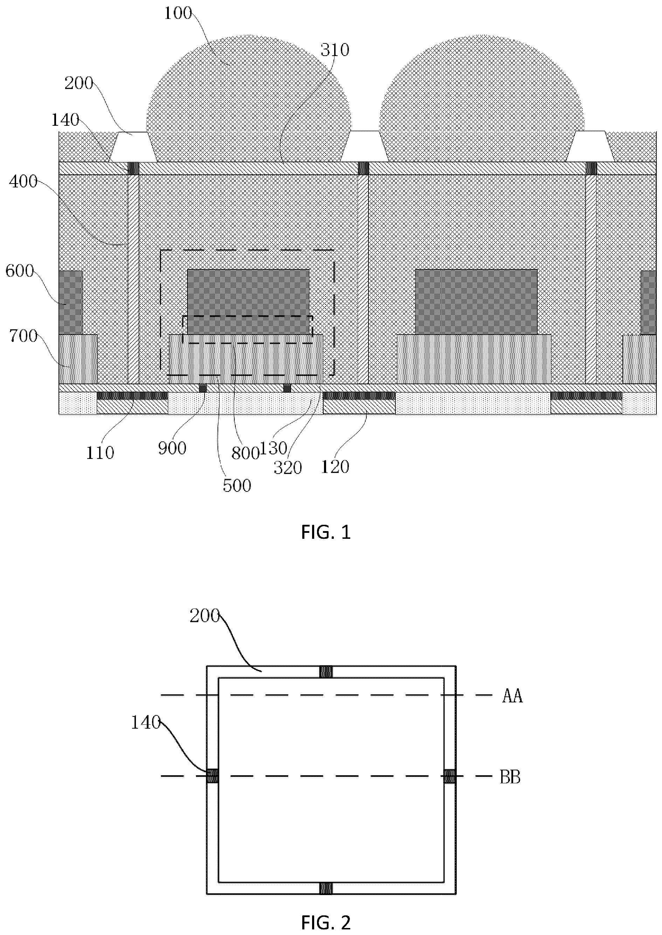

An embodiment of the present application provides a single photon avalanche diode array. As shown in FIG. 1, the single photon avalanche diode array includes: at least two SPAD units 500, at least two micro lenses 100, at least two front metal wiring layers 130, a back metal grid 200, a first dielectric layer 310, a second dielectric layer 320, a deep groove separation column 400, and a metal filling structure 140.

In an embodiment, at least two SPAD units 500 are arranged adjacent to each other, at least two micro lenses 100 correspond to at least two SPAD units 500 respectively, the micro lenses 100 are used to converge the incident light onto the corresponding SPAD unit 500, and at least two front metal wiring layers 130 correspond to at least two SPAD units 500. The back metal grid 200 is used to connect the SPAD unit 500 with the corresponding external electrode, the first dielectric layer 310 is arranged between the micro lens 100 and the SPAD unit 500, and the first dielectric layer 310 is used to reduce the reflection of the incident light; the second dielectric layer 320 is arranged between the SPAD unit 500 and the front metal wiring layer 130; wherein the front metal wiring layer 130 is electrically connected to the corresponding SPAD unit 500 through the contact wire 900. The deep groove separation column 400 is arranged between adjacent SPAD units 500, and the deep groove separation column 400 is used to separate the adjacent SPAD units 500; the metal filling structure 140 is arranged between the deep groove separation column 400 and the back metal grid 200, and the metal filling structure 140 is used to suppress the self-excited photons generated by the SPAD unit 500 excited by the incident light from entering the adjacent SPAD unit 500 through the grid gap.

In an embodiment, the micro lens 100 plays a role in converging light, converging the incident light to the corresponding SPAD unit 500, and the back metal grid 200 plays a role in leading one of the electrodes of the SPAD unit 500 out from the back. By setting a deep groove separation column 400 between adjacent SPAD units 500 and setting a metal filling structure 140 between the deep groove separation column 400 and the back metal grid 200, the deep groove separation column 400 can electrically isolate the adjacent SPAD units 500, and the self-excited photons generated by the SPAD unit 500 excited by the incident light can be reflected by the deep groove separation column 400, which increases absorption while preventing the self-excited photons from crosstalk to the adjacent SPAD unit 500, which to improve crosstalk. The metal filling structure 140 can isolate the self-excited photons generated by the SPAD unit 500 when excited by the incident light, reduce the crosstalk of the self-excited photons from the gap between the back metal grid 200 and the deep groove separation column 400 to the adjacent SPAD unit 500, reduce the overflow of the self-excited photons, reduce the probability of photon crosstalk, and reduce the optical crosstalk of the device.

In an embodiment, when there are multiple SPAD units 500, the multiple SPAD units 500 are arranged in an array. For example, when there are four SPAD units 500, the four SPAD units 500 are arranged in an array.

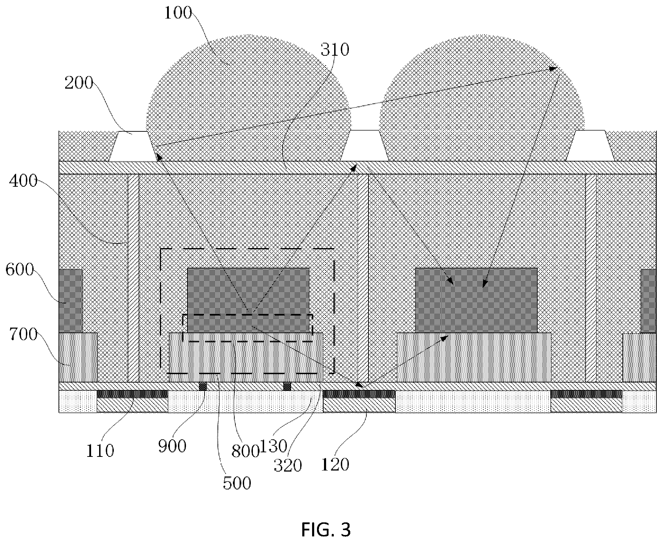

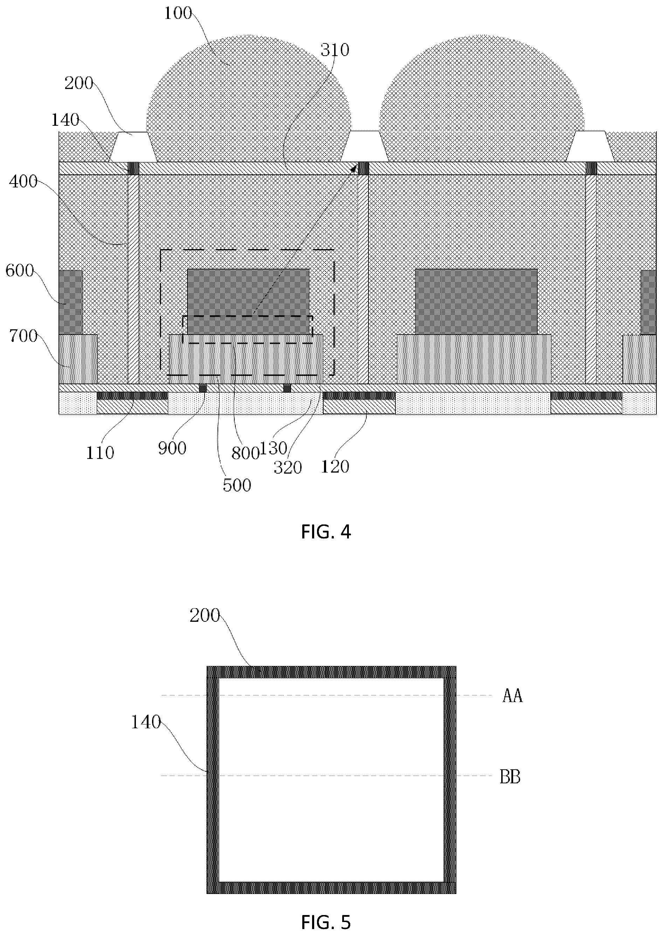

FIG. 2 is a schematic top view of a SPAD unit 500. At least two SPAD units 500 form a SPAD array. Each SPAD unit 500 is provided with a corresponding micro lens 100. The metal filling structure 140 is a metal connecting the deep groove separation column 400 and the back metal grid 200. FIG. 3 is a schematic cross-sectional view of the device section AA position in FIG. 2, and FIG. 4 is a schematic cross-sectional view of the device section BB position in FIG. 2. As shown in FIG. 4, due to the presence of the metal filling structure 140 at the section BB position, the crosstalk photons cannot pass through the dielectric gap between the back metal grid 200 and the deep groove separation column 400 to enter the adjacent SPAD unit 500. However, at the section AA position where the metal filling structure 140 is not filled (as shown in FIG. 3), a lot of unabsorbed light or self-excited photons will pass through the gap to enter the adjacent SPAD unit 500 to generate crosstalk.

In an embodiment, the metal filling structure 140 is a ring structure, as shown in FIG. 5. The shape of the metal filling structure 140 is the same as the shape of the back metal grid 200. The metal filling structure 140 can fill the gap between the back metal grid 200 and the deep groove separation column 400 around the SPAD unit 500, and can avoid the gap that appears at the position AA of the section as shown in FIG. 2. The gap that appears at the position AA of the section is filled by the metal filling structure 140. This part of the crosstalk will be suppressed, and the photons can be reflected back to the Si material of the substrate for reabsorption. It can improve the photon detection efficiency (PDE) to a certain extent, reduce the crosstalk of self-excited photons from the gap between the back metal grid 200 and the deep groove separation column 400 to the adjacent SPAD unit 500, reduce the overflow of self-excited photons, reduce the probability of photon crosstalk, and reduce the optical crosstalk of the device.

In some embodiments, the deep groove separation column 400 may be made of metal tungsten, and a dielectric material is filled around the deep groove separation column 400. The presence of the deep groove separation column 400 will reflect crosstalk photons, greatly reducing the probability of optical crosstalk.

In some embodiments, a width of the metal filling structure 140 is smaller than a width of the deep groove separation column 400.

In some embodiments, by selecting a suitable first dielectric layer 310 and second dielectric layer 320, and designing different dielectric layer refractive indices and film thicknesses, the first dielectric layer 310 and second dielectric layer 320 can form an optical filter to absorb or reflect photons of different wavelengths in self-excited photons, to reduce crosstalk of the device.

In some embodiments, in an array packaged SiPM device, a groove structure may be etched in the packaging structure, to reduce crosstalk between SiPMs.

In an embodiment, the SPAD unit 500 includes a first doping region 600 and a second doping region 700 stacked on a second dielectric layer, and the first doping region 600 and the second doping region 700 form a PN junction.

In some embodiments, the first doping region 600 and the second doping region 700 are two doping regions with different polarities, and a PN junction is formed between the first doping region 600 and the second doping region 700. The amplification region 800 is the region with the strongest electric field of the PN junction. The amplification region 800 is used for the generation and amplification of avalanches. The depletion region is a space charge region generated by the device under a certain voltage. The electrons or holes generated therein can enter the amplification region 800 through drift motion under the electric field to generate an avalanche.

In an embodiment, a vertical cross-section of the back metal grid 200 is an inverted trapezoid.

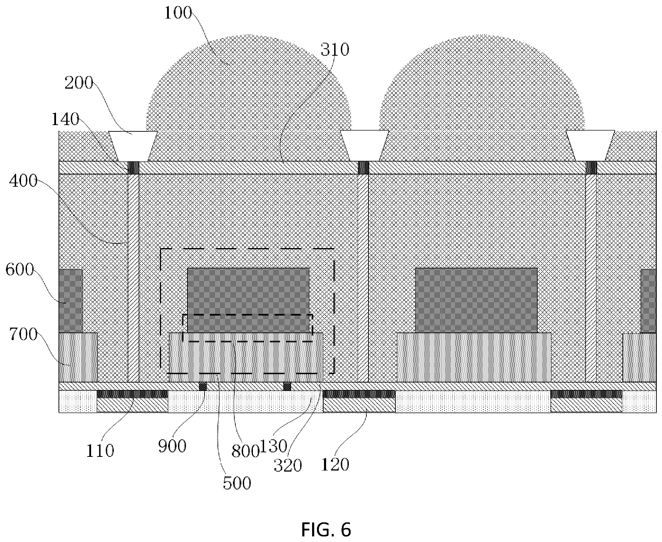

The path of optical crosstalk is shown in FIG. 3. Since the back metal grid 200 presents a regular trapezoidal morphology, the photons are reflected by the side walls of the back metal grid 200, that is, there is a high probability that they will enter other SPAD units. This crosstalk may propagate to a farther place due to the smaller reflection of the lens, causing crosstalk to the remote device, further aggravating the avalanche chain of crosstalk. As shown in FIG. 6, an inverted trapezoidal back metal grid 200 is used in this embodiment. The interface of the back metal grid 200 tilted inward will reflect the light incident thereon back into its own device, reducing the overflow of photons and reducing the crosstalk probability of self-excited photons.

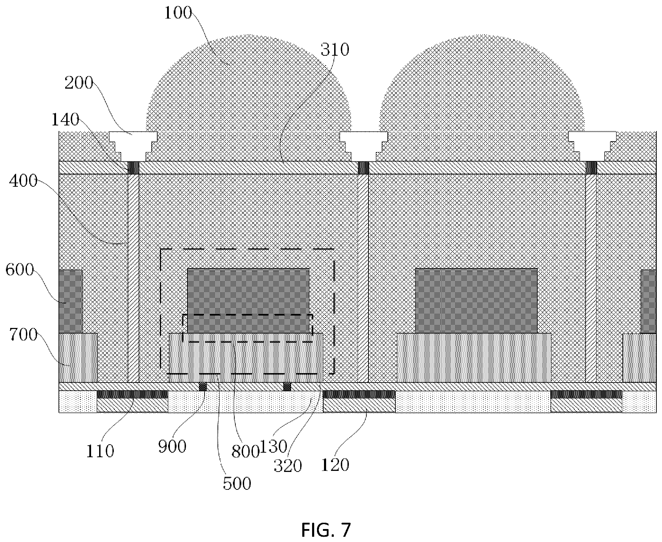

In an embodiment, as shown in FIG. 7, a vertical cross section of the back metal grid 200 is a multi-layer stepped structure, and a width of each step in the multi-layer stepped structure gradually increases.

In an embodiment, a vertical cross-section of the back metal grid 200 is a multi-layer stepped structure, and a width of the multi-layer stepped structure increases step by step, so that the back metal grid 200 tilts inward, reflecting the light incident on it back into its own device, reducing the overflow of photons, and reducing the probability of crosstalk of self-excited photons.

In an embodiment, the width of the multi-layer stepped structure increases step by step, and a width of the multi-layer stepped structure is arranged in an arithmetic progression.

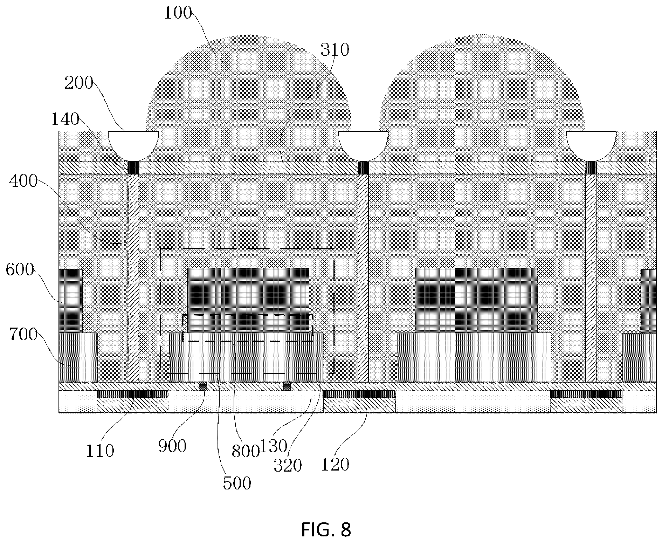

In an embodiment, as shown in FIG. 8, a vertical cross section of the back metal grid 200 is an arc-shaped structure, which is used to reflect the photons irradiated on its surface to the SPAD unit 500.

In an embodiment, by setting the vertical cross-section of the back metal grid 200 to be an arc-shaped structure, the interface between the back metal grid 200 and the micro lens 100 can form a total reflection interface inclined toward the SPAD unit 500 on the inside, and the photons irradiated on its surface are reflected to the SPAD unit 500 (that is, the interval of the SPAD unit 500 itself), thereby reducing the overflow of self-excited photons and reducing the probability of crosstalk of self-excited photons.

In an embodiment, as shown in FIG. 8, an intermetallic dielectric layer 120 is provided between adjacent front metal wiring layers 130, an etch stop layer 110 is provided between the intermetallic dielectric layer 120 and the deep groove separation column 400, the deep groove separation column 400 penetrates into the etch stop layer 110, and divides the second dielectric layer 320 into at least two dielectric units, and at least two dielectric units correspond to the SPAD unit 500, which can block the crosstalk light reflected by the front metal wiring layer 130 and the etch stop layer 110.

In an embodiment, since the first doped region 600 and the second doped region 700 have a certain thickness, the deep groove separation column 400 penetrates into the second dielectric layer 320. When the length of the portion of the deep groove separation column 400 that penetrates into the second dielectric layer 320 is greater than half of the thickness of the second dielectric layer 320, the crosstalk light reflected by the front metal routing layer 130 and the etch stop layer 110 can be blocked.

In an embodiment, a length of the portion of the deep groove separation column 400 that penetrates into the second dielectric layer 320 can be set according to a width of the deep groove separation column 400.

In an embodiment, a thickness of the portion of the deep groove separation column 400 extending into the second dielectric layer 320 may be smaller than a thickness of the second dielectric layer 320.

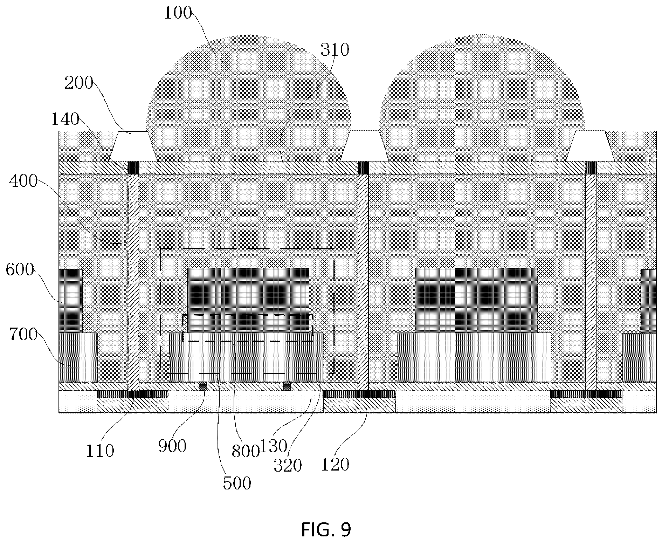

In an embodiment, in a single photon avalanche diode array, the metal filling structure 140 is a ring structure, which can fill the gap between the back metal grid 200 and the deep groove separation column 400 around the SPAD unit 500, and can avoid the gap that appears at the section AA position in FIG. 2. This part of the crosstalk will be suppressed, and combined with the deep groove separation column 400 deep into the etch stop layer 110, a crosstalk prevention combination scheme of deep groove separation extension and metal filling structure ring is formed, as shown in FIG. 9.

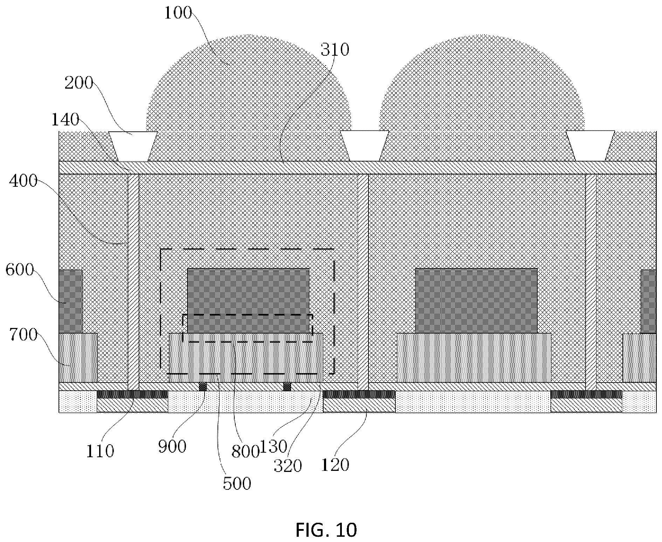

In an embodiment, in a single-photon avalanche diode array, as shown in FIG. 10, the back metal grid 200 has an inverted trapezoidal morphology. The interface of the back metal grid 200 tilted inward will reflect the light incident thereon back into its own device, reducing the overflow of photons and the crosstalk probability of self-excited photons. Combined with the deep groove separation column 400 that penetrates into the etch stop layer 110, the probability of photon crosstalk from the bottom is reduced. The anti-crosstalk combination solution formed by the deep groove separation extension and the inverted trapezoidal back metal grid 200 can effectively reduce the interference of crosstalk photons on adjacent SPAD units 500.

In an embodiment, based on the metal filling structure 140 being a ring structure and the deep groove separation column 400 extending deep into the etch stop layer 110, the cross-section of the back metal grid is set to an inverted trapezoid, thereby forming an anti-crosstalk combination scheme of a deep groove separation extension, a metal filling structure ring, and an inverted trapezoid of the back metal grid, as shown in FIG. 10.

In the above-mentioned BSI device structure, the deep groove separation column 400 can block most of the crosstalk photons, but there are still several paths that can obviously cause crosstalk that have not been resolved, making it not easy to further reduce the crosstalk.

As shown in FIG. 1, the deep groove separation column 400 stays above the second dielectric layer 320. A crosstalk photons can be reflected into the adjacent SPAD unit 500 through the front metal wiring layer 130, or can be reflected into the adjacent SPAD unit 500 through the interface formed by the etch stop layer 110 and the second dielectric layer 320. In order to reduce the probability of photon crosstalk from the bottom, the deep groove separation column 400 is extended downward to the etch stop layer in this embodiment, to block the crosstalk light reflected by the front metal wiring layer 130 and the etch stop layer 110.

In some embodiments, the etch stop layer 110 may be a silicon carbon nitride (SiCN) material.

In an embodiment, the deep groove separation column 400 is made of metal tungsten.

In an embodiment, when the self-excited photons generated by the SPAD unit 500 after being illuminated propagate within the device, the light incident on the deep groove separation columns 400 around it will be repeatedly reflected, which increases absorption while also preventing the photons from crosstalk into adjacent units. Therefore, setting deep groove separation columns 400 around the SPAD unit 500 is also an important way to improve crosstalk.

In an embodiment, the back metal grid 200 is aluminum.

In some embodiments, multiple layers of metal wiring may be formed in the front metal wiring layer 130, to lead another electrode of the SPAD unit 500 to the front electrode, and corresponding electrical signals may also be output through the front metal wiring layer 130.

In order to illustrate the effect and level of improving the optical crosstalk of the single photon avalanche diode array, a simulation verification of the optical crosstalk of the single photon avalanche diode array is performed below.

In an embodiment, optical crosstalk probability OXT is calculated as:

$$OXT = \int PPS(\lambda) \cdot Gain(\int_V G(r) \cdot ATP(r)dV) \, d\lambda \quad ; \quad \text{(Formula 1)}$$

Wherein, G(r) is the carrier rate generated after the adjacent SPAD unit 500 absorbs the crosstalk light of the central SPAD unit 500; ATP(r) is the carrier avalanche probability in the depletion region; Gain is the number of carriers released each time an avalanche occurs in the SPAD unit 500, that is, the gain; PPS($\lambda$) is the avalanche photon generation spectrum, and its physical meaning is the distribution of the average number of photons released by each carrier in each avalanche with the wavelength.

In the calculation, G(r) can be obtained by optical simulation, random photons are placed in the central SPAD unit 500, the spectral width of the random photons is 0.4-1um, the intensity of each photon is set according to PPS($\lambda$), and the spontaneous spectrum of avalanche photons is referred to. Then, the absorbed light power is monitored in the adjacent SPAD unit 500, and then converted into the carrier generation rate. ATP(r) can be calculated according to the electric field size of the SPAD unit 500, and the McIntyre model can be used to calculate the probability of avalanche triggering at different positions. The Gain is 0.8M in the calculation. In the simulation, since the self-excited photons have random positions and random radiation directions, the present application sets the self-excited photons to be generated in 3 different positions (device left, middle, and right) in the simulation, and uses 3 dipole polarization directions (X, Y, Z) for the radiation direction of the photons, and takes the average of 9 simulation results as the OXT radiation probability.

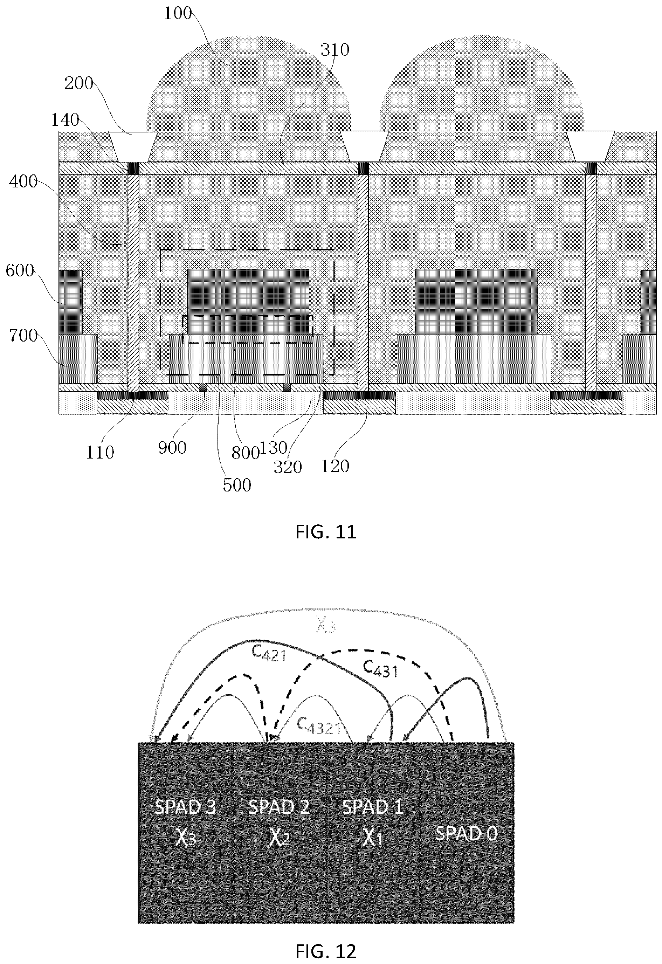

When calculating the overall crosstalk of a one-dimensional long array SPAD, since it is difficult to perform optical simulation for a large number of SPADs, an embodiment discloses use a 4-SPADs model to approximate the one-dimensional long array, as shown in FIG. 11. Consider the crosstalk situation when there are three devices, that is, consider the crosstalk situation of SPAD2. After the self-excited photons are generated by SPADO, SPAD1 avalanche is triggered with a certain probability. The avalanche of SPAD1 also has a probability of generating photons to further trigger the avalanche of SPAD2. Therefore, the crosstalk of SPAD2 can be generated by direct crosstalk of SPAD0 (with a probability of $\chi 2$), or by the SPAD0 $\rightarrow$SPAD1 $\rightarrow$SPAD2 link. Since these two paths can occur almost simultaneously, the probability of SPAD2 receiving optical crosstalk is the sum of the probabilities of the two links, minus the probability of simultaneous occurrence, which can be expressed by Formula 2, where $\chi 1$ is the probability of direct crosstalk between two adjacent SPADs:

$$\text{OXT3-spad} = \chi 1 +(\chi 2 +\chi 1\cdot\chi 1- \chi 2\cdot\chi 1\cdot\chi 1); \quad \text{(Formula 2)}$$

Further, the simulation model is extended to 4-spads, and the crosstalk chain can be referred to as shown in FIG. 10. Therefore, under the 4-spads model, the crosstalk of the one-dimensional array SPAD unit 500 can be calculated by Formula 3:

$$\text{OXT4 -spad} =\chi 1 +(\chi 2 +\chi 1\bullet\chi 1- \chi 2\bullet\chi 1\bullet\chi 1)+ \chi 3+ 2\bullet\chi 1\bullet\chi 2+ \chi 1\char`^3- 2\bullet\chi 1\bullet\chi 2\bullet\chi 3-\chi 3\bullet\chi 1\char`^3- \chi 1\char`^2\bullet \chi 2\char`^2- 2\bullet\chi 1\char`^3\bullet\chi 2+ \chi 1\char`^2\bullet\chi 2\char`^2\bullet\chi 3 + 2\bullet\chi 1\char`^3\bullet\chi 2\bullet\chi 3 + \chi 1\char`^3\bullet\chi 2\char`^2 - \chi 1\char`^3\bullet\chi 2\char`^2\bullet\chi 3;$$

$$\text{(Formula 3)}$$

In Formula 3, $\chi i$ (i =1, 2, 3) represents the probability that SPAD0 generates crosstalk to the ith SPAD unit 500, which can be obtained by optical simulation combined with Formula 1. Thus, the optical crosstalk model of the one-dimensional long linear array SPAD is obtained.

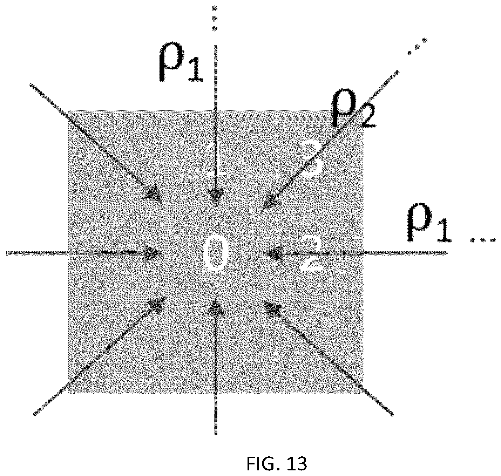

On this basis, embodiments of the present application adopt a similar method to extend it to a 2D array. Referring to FIG. 13, the crosstalk to SPAD0 comes from eight surrounding directions. According to symmetry, the horizontal crosstalk $\rho 1$ and the diagonal crosstalk $\rho 2$ need to be simulated and calculated.

In an embodiment, adopts an approximate method to simulate an infinite 2D array, that is, a one-dimensional 4-spads model is used to obtain an approximate horizontal crosstalk $\rho 1$, which is used to equivalently calculate the crosstalk of SPAD1 and SPAD2 to SPAD0 in FIG. 11; and then the crosstalk size of SPAD in the oblique direction is simulated to obtain $\rho 2$ , which is equivalent to the crosstalk of SPAD3 to SPAD0 in FIG. 12.

At this time, SPAD0 is subject to two crosstalk paths, namely SPAD1$\rightarrow$ SPAD0 and SPAD3$\rightarrow$ SPAD1 $\rightarrow$SPAD0. The model ignores some paths that may exist in theory but have a small probability in practice, such as SPAD3 $\rightarrow$SPAD1 $\rightarrow$ SPAD2 $\rightarrow$SPAD0. In an embodiment, the crosstalk model of the entire 2D array is given by Formula 4:

$$\text{OXT}_{-2D} =4\rho 1 +4\rho 2 +4(\rho 1 \bullet\rho 2 -\rho 1 \bullet\rho 1 \bullet\rho 2); \quad \text{(Formula 4)}$$

According to the crosstalk improvement effect in an embodiment, simulation verification is performed in sequence, and the crosstalk improvement effect is compared with the crosstalk performance of the traditional device structure simulation, refer to Table 1.

Table 1

| simulation / Model | χ1 | χ2 | χ3 | ρ1 | ρ2 | OXT$_{-2D}$ |
|---|---|---|---|---|---|---|
| Traditional structure | 0.311 % | 0.091 % | 0.058 % | 0.624 % | 0.405 % | 4.50 % |
| Deep Groove Separation Extension | 0.257 % | 0.080 % | 0.023 % | 0.475 % | 0.181 % | 2.80 % |
| Metal filled structural ring | 0.239 % | 0.085 % | 0.026 % | 0.453 % | 0.198 % | 2.80 % |
| Deep Groove Separation Extension & Metal filled structural ring | 0.183 % | 0.083 % | 0.024 % | 0.355 % | 0.134 % | 2.08 % |
| Deep Groove Separation Extension & Metal Filled Structural Rings & Back metal grid inverted trapezoid | 0.080 % | 0.132 % | 0.022 % | 0.261 % | 0.119 % | 1.61 % |

From the simulation data in Table 1, the crosstalk performance has been improved. When the deep groove separation column 400 process is optimized alone, the crosstalk probability in both the horizontal and diagonal directions is reduced, and the total OXT is finally reduced to 60 % of the original; the optimization scheme of the metal filling structure 140 closed loop is adopted alone, and the same improvement effect is achieved; the deep groove separation extension scheme and the metal filling structure 140 closed loop scheme are adopted at the same time, and the crosstalk performance is further reduced, especially the χ1 probability, that is, the crosstalk suppression of the nearest neighboring SPAD unit 500 is obvious, and OXT is reduced to 46% of the original; and the comprehensive scheme proposed in an embodiment (as shown in FIG. 11) is adopted, OXT is reduced to 36 % of the original, especially the improvement of the nearest neighboring SPAD unit 500.

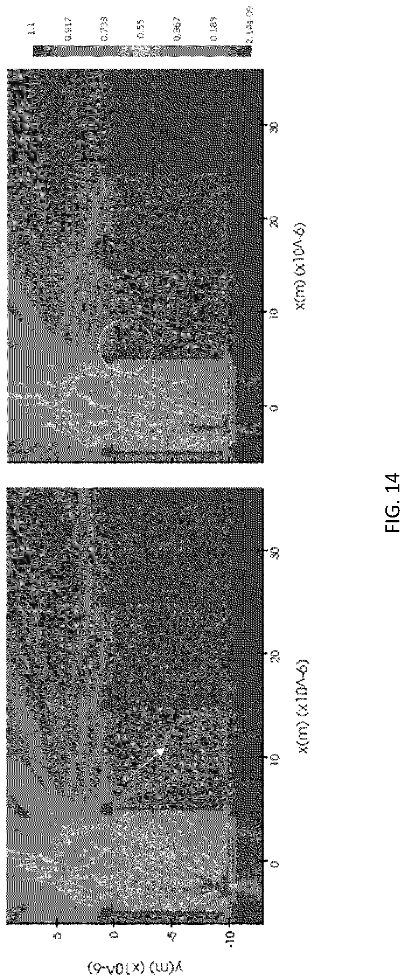

FIG. 14 to FIG. 17 more intuitively show the optical crosstalk improvement effect of some embodiments. FIG. 14 shows a self-excited optical crosstalk of the traditional structure and the crosstalk of the metal filling structure 140 extension structure. The SPAD unit 500 on the far left of FIG. 14 generates self-excited photons by avalanche. FIG. 14 shows a situation where the photon position is located to the left of the device. By comparing the left and right figures, it can be intuitively seen that the metal filling structure 140 closed loop solution (as shown in FIG. 1) significantly suppresses the crosstalk light of this path.

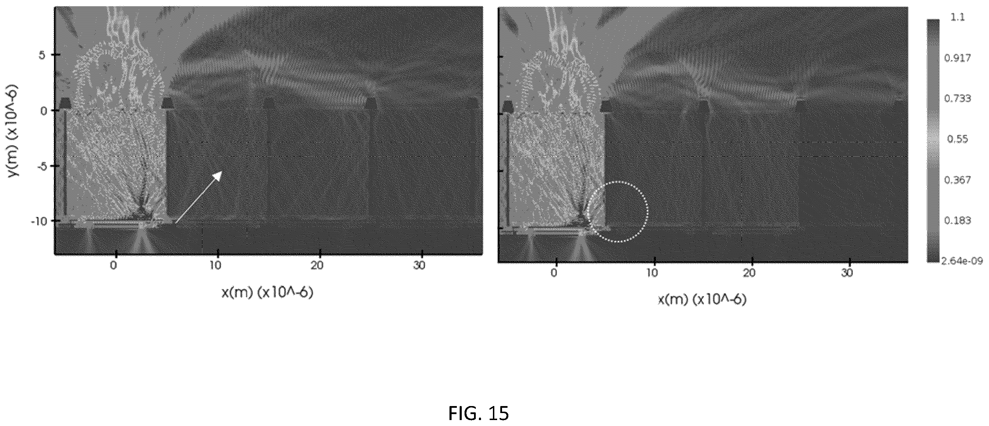

FIG. 15 shows a crosstalk between the conventional structure and the deep groove separation extension structure. When the deep groove separation is extended to the etch stop layer, the crosstalk light at the bottom is suppressed.

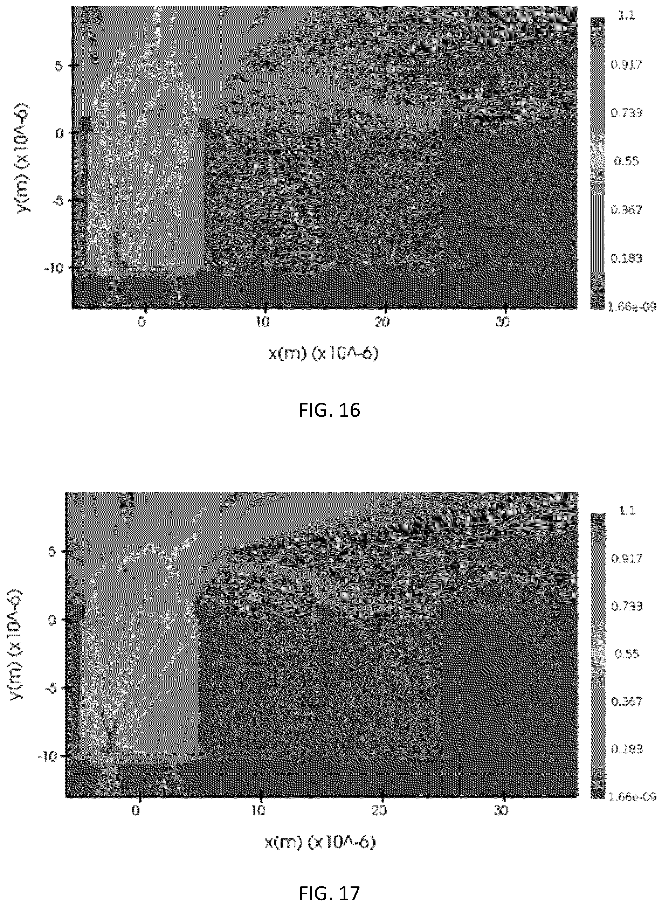

FIG. 16 shows the crosstalk of self-excited photons when both deep groove separation extension and metal filling structure 140 closed loop solution (as shown in FIG. 9) are used. A crosstalk light from the bottom of the back metal grid 200 and the bottom of the deep groove separation column 400 has been reduced, and the main crosstalk comes from the lens part.

FIG. 17 shows a situation when the comprehensive improvement scheme (such as FIG. 11) is adopted. The back metal grid 200 adopts an inverted trapezoid so that a large part of the crosstalk light is reflected back to its own SPAD unit, and the optical crosstalk of its adjacent devices is significantly suppressed, thereby reducing the optical crosstalk of the entire two-dimensional array. The gain used in the model calculation of this scheme is small, and the value of the self-excited photon radiation spectrum is also small. Therefore, when the incident light intensity is increased and the overvoltage is increased, the improvement of the optical crosstalk performance will be more significant.

The embodiment of the present application further provides a silicon photomultiplier tube, which includes a single photon avalanche diode array.

Incident light is focused onto the corresponding SPAD unit through a micro lens, a back metal grid connects the SPAD unit to the corresponding external electrode, a first dielectric layer is arranged between the micro lens and the SPAD unit, a second dielectric layer is arranged between the SPAD unit and the front metal wiring layer, and the front metal wiring layer is electrically connected to the corresponding SPAD unit through a contact metal wire. By arranging deep groove separation columns between adjacent SPAD units and arranging a metal filling structure between the deep groove separation columns and the back metal grid, self-excited photons generated by the SPAD unit excited by incident light can be isolated, and self-excited photons are prevented from entering the adjacent SPAD unit through the grid gap, thereby reducing the overflow of self-excited photons, reducing the probability of photon crosstalk, and reducing the optical crosstalk of the device.

Embodiments of the present application include a receiving sensor, which may include one or more of the above-mentioned single photon avalanche diode arrays or one or more of the above-mentioned silicon photomultiplier tubes.

Embodiments of the present application includes a LiDAR, which includes an emitting sensor and the above-mentioned receiving sensor, the emitting sensor is used to emit a detection laser, and the receiving sensor is used to receive an echo of the detection laser, and obtain a target object based on the echo.

The division of the above-mentioned functional device areas and modules is used as an example, the above-mentioned functions can be distributed and completed by different functional device areas and modules, that is, the internal structure of the device is divided into different functional device areas or modules to complete all or part of the functions described above. The functional device areas and modules in the embodiments can be integrated into one device, or each unit can exist physically separately, or two or more units can be integrated into one unit.

The names of the functional device areas and modules are only for the convenience of distinguishing each other. The working process of the units and modules in the above system can refer to the corresponding process in the above method embodiment.

Each functional device area in embodiment may be integrated into one device, or each unit may exist physically separately, or two or more units may be integrated into one unit.

## Claims

1. A back-illuminated single photon avalanche diode, SPAD, array, comprises:

   at least two SPAD units (500);
   at least two micro lenses (100), corresponding to the at least two SPAD units (500) respectively, and each of the at least two micro lenses (100) is configured to focus an incident light onto the corresponding SPAD unit;
   at least two front metal wiring layers (130), wherein the at least two front metal wiring layers (130) correspond one-to-one to the at least two SPAD units (500);
   a back metal grid (200), configured to connect the SPAD unit (500) to a corresponding external electrode;
   a first dielectric layer (310), disposed between the micro lens (100) and the SPAD unit (500) and configured to reduce reflection of the incident light;
   a second dielectric layer (320), disposed between the SPAD unit (500) and the front metal wiring layer (130), wherein the front metal wiring layer (130) is electrically connected to the corresponding SPAD unit (500) through a contact metal wire; and
   a deep groove separation column(400), provided between adjacent SPAD units and configured to separate the adjacent SPAD units(500);
   **characterized in that**:

   the SPAD array further comprises a metal filling structure, arranged between the deep groove separation column and the back metal grid (200), and configured to suppress self-excited photons generated by the SPAD units (500) excited by the incident light from entering adjacent SPAD units (500) through a grid gap; and the metal filling structure (140) is a ring structure and is configured to fill the gap between the back metal grid (200) and the deep groove separation column (400) around the SPAD unit (500).

2. The single photon avalanche diode array according to claim 1, wherein a vertical cross-section of the back metal grid is an inverted trapezoid.

3. The single-photon avalanche diode array according to claim 1, wherein a vertical cross-section of the back metal grid is a multi-layer stepped structure, and a width of each step in the multi-layer stepped structure gradually increases.

4. The single photon avalanche diode array according to claim 1, wherein a vertical cross-section of the back metal grid is an arc-shaped structure, which is configured to reflect photons irradiating its surface to the SPAD unit.

5. The single photon avalanche diode array according to any one of claims 1 to 4, wherein an intermetallic dielectric layer is provided between adjacent front metal wiring layers, an etch stop layer is provided between the intermetallic dielectric layer and the deep groove separation column, the deep groove separation column penetrates into the etch stop layer and divides the second dielectric layer into at least two dielectric units, and at least two dielectric units correspond to the SPAD unit.

6. The single photon avalanche diode array according to any one of claims 1 to 4, wherein an intermetallic dielectric layer is provided between adjacent front metal wiring layers, an etch stop layer is provided between the intermetallic dielectric layer and the deep groove separation column, and a length of a portion of the deep groove separation column that penetrates into the second dielectric layer is greater than half of the thickness of the second dielectric layer.

7. The single photon avalanche diode array according to any one of claims 1 to 4, wherein the SPAD unit includes a first doped region and a second doped region stacked on the second dielectric layer, and the first doped region and the second doped region form a PN junction.

8. The single photon avalanche diode array according to any one of claims 1 to 4, wherein the deep groove separation column is made of metal tungsten.

9. A receiving sensor, wherein the receiving sensor comprises a single photon avalanche diode array according to any one of claims 1 to 8.

10. A LiDAR, wherein the LiDAR comprises an emitting sensor and a receiving sensor according to claim 9;

the emitting sensor is configured to emit detection laser; and
the receiving sensor is configured to receive the echo of the detection laser and obtain detection information of a target object according to the echo.

**Patentansprüche**

1. Rückseitig beleuchtetes Einzelphotonen-Lawinendioden-Array, SPAD-Array, umfassend:

mindestens zwei SPAD-Einheiten (500);
mindestens zwei Mikrolinsen (100), die den mindestens zwei SPAD-Einheiten (500) jeweils entsprechen, wobei jede der mindestens zwei Mikrolinsen (100) dazu ausgebildet ist, einfallende Strahlung auf die entsprechende SPAD-Einheit zu fokussieren;
mindestens zwei vorderseitige Metallleitungsschichten (130), wobei die mindestens zwei vorderseitigen Metallleitungsschichten (130) den mindestens zwei SPAD-Einheiten (500) einszu-eins entsprechen;
ein rückseitiges Metallgitter (200), das dazu ausgebildet ist, die SPAD-Einheit (500) mit einer entsprechenden externen Elektrode zu verbinden;
eine erste dielektrische Schicht (310), die zwischen der Mikrolinse (100) und der SPAD-Einheit (500) angeordnet und dazu ausgebildet ist, die Reflexion der einfallenden Strahlung zu reduzieren;
eine zweite dielektrische Schicht (320), die zwischen der SPAD-Einheit (500) und der vorderseitigen Metallleitungsschicht (130) angeordnet ist, wobei die vorderseitige Metallleitungsschicht (130) über eine Kontaktmetallleiterbahn elektrisch mit der entsprechenden SPAD-Einheit (500) verbunden ist; und

eine Tiefgrabentrennungssäule (400), die zwischen benachbarten SPAD-Einheiten vorgesehen und dazu ausgebildet ist, die benachbarten SPAD-Einheiten (500) voneinander zu trennen;

**dadurch gekennzeichnet, dass**:

das SPAD-Array ferner eine Metallauffüllstruktur umfasst, die zwischen der Tiefgrabentrennungssäule und dem rückseitigen Metallgitter (200) angeordnet und dazu ausgebildet ist, zu unterdrücken, dass eigenangeregte Photonen, die durch die von der einfallenden Strahlung angeregten SPAD-Einheiten (500) erzeugt werden, über einen Gitterspalt in benachbarte SPAD-Einheiten (500) eintreten; und

die Metallauffüllstruktur (140) eine Ringstruktur ist und dazu ausgebildet ist, den Spalt zwischen dem rückseitigen Metallgitter (200) und der Tiefgrabentrennungssäule (400) um die SPAD-Einheit (500) herum zu füllen.

2. Einzelphotonen-Lawinendioden-Array nach Anspruch 1, wobei ein vertikaler Querschnitt des rückseitigen Metallgitters ein umgekehrtes Trapez ist.

3. Einzelphotonen-Lawinendioden-Array nach Anspruch 1, wobei ein vertikaler Querschnitt des rückseitigen Metallgitters eine mehrschichtige Treppenstruktur ist und eine Breite jeder Stufe in der mehrschichtigen Treppenstruktur allmählich zunimmt.

4. Einzelphotonen-Lawinendioden-Array nach Anspruch 1, wobei ein vertikaler Querschnitt des rückseitigen Metallgitters eine bogenförmige Struktur ist, die dazu ausgebildet ist, auf ihre Oberfläche auftreffende Photonen zur SPAD-Einheit hin zu reflektieren.

5. Einzelphotonen-Lawinendioden-Array nach einem der Ansprüche 1 bis 4, wobei zwischen benachbarten vorderseitigen Metallleitungsschichten eine intermetallische dielektrische Schicht vorgesehen ist, wobei zwischen der intermetallischen dielektrischen Schicht und der Tiefgrabentrennungssäule eine Ätzstoppschicht vorgesehen ist, wobei die Tiefgrabentrennungssäule in die Ätzstoppschicht eindringt und die zweite dielektrische Schicht in mindestens zwei dielektrische Einheiten unterteilt, und wobei mindestens zwei dielektrische Einheiten der SPAD-Einheit entsprechen.

6. Einzelphotonen-Lawinendioden-Array nach einem der Ansprüche 1 bis 4, wobei zwischen benachbarten vorderseitigen Metallleitungsschichten eine intermetallische dielektrische Schicht vorgesehen ist, wobei zwischen der intermetallischen dielektrischen Schicht und der Tiefgrabentrennungssäule eine Ätzstoppschicht vorgesehen ist, und wobei eine Länge eines in die zweite dielektrische Schicht eindringenden Abschnitts der Tiefgrabentrennungssäule größer als die Hälfte der Dicke der zweiten dielektrischen Schicht ist.

7. Einzelphotonen-Lawinendioden-Array nach einem der Ansprüche 1 bis 4, wobei die SPAD-Einheit einen ersten dotierten Bereich und einen zweiten dotierten Bereich umfasst, die auf der zweiten dielektrischen Schicht gestapelt sind, und wobei der erste dotierte Bereich und der zweite dotierte Bereich einen PN-Übergang bilden.

8. Einzelphotonen-Lawinendioden-Array nach einem der Ansprüche 1 bis 4, wobei die Tiefgrabentrennungssäule aus Metallwolfram hergestellt ist.

9. Empfangssensor, wobei der Empfangssensor ein Einzelphotonen-Lawinendioden-Array nach einem der Ansprüche 1 bis 8 umfasst.

10. LiDAR, wobei das LiDAR einen Sendesensor und einen Empfangssensor nach Anspruch 9 umfasst;

der Sendesensor dazu ausgebildet ist, einen Detektionslaser auszusenden; und

der Empfangssensor dazu ausgebildet ist, das Echo des Detektionslasers zu empfangen und gemäß dem Echo Detektionsinformationen über ein Zielobjekt zu erlangen.

**Revendications**

1. Tableau de photodiodes à avalanche de photon unique (SPAD) à illumination par la face arrière, comprenant :

au moins deux unités SPAD (500) ;

au moins deux microlentilles (100), correspondant respectivement aux au moins deux unités SPAD (500), chacune des au moins deux microlentilles (100) étant configurée pour focaliser une lumière incidente sur l'unité SPAD correspondante ;

au moins deux couches de câblage métallique frontal (130), les au moins deux couches de câblage métallique frontal (130) correspondant en bijection aux au moins deux unités SPAD (500) ;

une grille métallique arrière (200), configurée pour connecter l'unité SPAD (500) à une électrode externe correspondante ;

une première couche diélectrique (310), disposée entre la microlentille (100) et l'unité SPAD (500) et configurée pour réduire la réflexion de la lumière incidente ;

une deuxième couche diélectrique (320), disposée entre l'unité SPAD (500) et la couche de câblage métallique frontal (130), la couche de câblage métallique frontal (130) étant connectée électriquement à l'unité SPAD (500) correspondante par l'intermédiaire d'un fil métallique de contact ; et

une colonne de séparation à tranchée profonde (400), prévue entre des unités SPAD adjacentes et configurée pour séparer les unités SPAD adjacentes (500) ;

**caractérisé en ce que** :

le tableau SPAD comprend en outre une structure de remplissage métallique, disposée entre la colonne de séparation à tranchée profonde et la grille métallique arrière (200), et configurée pour supprimer les photons auto-excités générés par les unités SPAD (500) excitées par la lumière incidente de pénétrer dans des unités SPAD (500) adjacentes à travers un interstice de grille ; et

la structure de remplissage métallique (140) est une structure annulaire et est configurée pour combler l'interstice entre la grille métallique arrière (200) et la colonne de séparation à tranchée profonde (400) autour de l'unité SPAD (500).

2. Tableau de photodiodes à avalanche de photon unique selon la revendication 1, dans lequel une section transversale verticale de la grille métallique arrière est un trapèze inversé.

3. Tableau de photodiodes à avalanche de photon unique selon la revendication 1, dans lequel une section transversale verticale de la grille métallique arrière est une structure en escaliers multicouches, et une largeur de chaque marche dans la structure en escaliers multicouches augmente progressivement.

4. Tableau de photodiodes à avalanche de photon unique selon la revendication 1, dans lequel une section transversale verticale de la grille métallique arrière est une structure en arc, configurée pour réfléchir les photons irradiant sa surface vers l'unité SPAD.

5. Tableau de photodiodes à avalanche de photon unique selon l'une quelconque des revendications 1 à 4, dans lequel une couche diélectrique intermétallique est prévue entre des couches de câblage métallique frontal adjacentes, une couche d'arrêt de gravure est prévue entre la couche diélectrique intermétallique et la colonne de séparation à tranchée profonde, la colonne de séparation à tranchée profonde pénètre dans la couche d'arrêt de gravure et divise la deuxième couche diélectrique en au moins deux unités diélectriques, et au moins deux unités diélectriques correspondent à l'unité SPAD.

6. Tableau de photodiodes à avalanche de photon unique selon l'une quelconque des revendications 1 à 4, dans lequel une couche diélectrique intermétallique est prévue entre des couches de câblage métallique frontal adjacentes, une couche d'arrêt de gravure est prévue entre la couche diélectrique intermétallique et la colonne de séparation à tranchée profonde, et une longueur d'une portion de la colonne de séparation à tranchée profonde qui pénètre dans la deuxième couche diélectrique est supérieure à la moitié de l'épaisseur de la deuxième couche diélectrique.

7. Tableau de photodiodes à avalanche de photon unique selon l'une quelconque des revendications 1 à 4, dans lequel l'unité SPAD comprend une première région dopée et une deuxième région dopée empilées sur la deuxième couche diélectrique, et la première région dopée et la deuxième région dopée forment une jonction PN.

8. Tableau de photodiodes à avalanche de photon unique selon l'une quelconque des revendications 1 à 4, dans lequel la colonne de séparation à tranchée profonde est fabriquée en tungstène métallique.

9. Capteur de réception, dans lequel le capteur de réception comprend un tableau de photodiodes à avalanche de photon unique selon l'une quelconque des revendications 1 à 8.

**10.** LiDAR, dans lequel le LiDAR comprend un capteur d'émission et un capteur de réception selon la revendication 9 ;

le capteur d'émission est configuré pour émettre un laser de détection ; et
le capteur de réception est configuré pour recevoir l'écho du laser de détection et obtenir des informations de détection d'un objet cible en fonction de l'écho.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

FIG. 17

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2021183930 A1